Europäisches Patentamt

European Patent Office

Office européen des brevets

(19)

(11) **EP 0 746 070 B1**

(12) **FASCICULE DE BREVET EUROPEEN**

(45) Date de publication et mention
de la délivrance du brevet:
**24.05.2000  Bulletin 2000/21**

(51) Int Cl.[7]: **H01S 5/40**, H04B 10/17,
G02F 3/00

(21) Numéro de dépôt: **96401117.5**

(22) Date de dépôt: **23.05.1996**

(54) **Procédé et dispositif pour combiner des signaux optiques**

Verfahren und Vorrichtung zur Kombination optischer Signale

Method and device to combine optical signals

(84) Etats contractants désignés:
**AT BE CH DE ES FR GB IT LI NL SE**

(30) Priorité: **29.05.1995  FR 9506318**

(43) Date de publication de la demande:
**04.12.1996  Bulletin 1996/49**

(73) Titulaire: **ALCATEL**
**75008 Paris (FR)**

(72) Inventeurs:
• **Sotom, Michel**
**75015 Paris (FR)**
• **Gabriagues, Jean-Michel**
**92600 Asnières (FR)**
• **Chauzat, Corinne**
**94000 Créteil (FR)**
• **Chiaroni, Dominique**
**92160 Antony (FR)**
• **De Bouard, Dominique**
**91700 Ste Geneviève des Bois (FR)**

(74) Mandataire: **Fournier, Michel Robert Marie et al**
**COMPAGNIE FINANCIERE ALCATEL**
**Département Propriété Industrielle**
**30, avenue Kléber**
**75116 Paris (FR)**

(56) Documents cités:
**WO-A-95/10795**          **US-A- 4 980 891**
**US-A- 5 264 960**

• **19TH EUROPEAN CONFERENCE ON OPTICAL
COMMUNICATION (ECOC), vol. 2, 12 Septembre
1993, MONTREUX, CH, pages 133-136,
XP000492189 R.SCHNABEL ET AL.: "All-optical
AND gate using femtosecond nonlinear gain
dynamics in semiconductor amplifiers"**
• **OSA PROCEEDINGS ON PHOTONICS IN
SWITCHING, vol. 16, 15 Mars 1993,
WASHINGTON, US, pages 207-210,
XP000473865 M.EISELT ET AL.: "All-optical
regenerator using a semiconductor laser
amplifier in a loop mirror configuration"**

## Description

L'invention se situe dans le domaine des systèmes optoélectroniques applicables notamment pour réaliser la transmission ou la commutation de données numériques.

Un premier but de l'invention est de réaliser par des moyens exclusivement optiques des combinaisons de signaux optiques modulés, c'est-à-dire de réaliser des opérations logiques portant sur des signaux modulant des ondes optiques.

De telles opérations sont utiles par exemple pour modifier un train de données binaires ayant la forme d'impulsions modulant une porteuse optique. Il est en effet utile de pouvoir effectuer des effacements en supprimant sélectivement certaines de ces impulsions ou d'insérer des informations binaires en inversant les niveaux de ces impulsions. Des opérations logiques peuvent également servir à des fins de resynchronisation par exemple pour supprimer la gigue, c'est-à-dire les fluctuations de phase des fronts montants ou descendants des impulsions.

Jusqu'à présent, le problème de l'insertion de données binaires était résolu en utilisant des coupleurs optiques. Cependant, cette solution n'est pas satisfaisante car elle nécessite une source optique dont la longueur d'onde est égale à celle de la porteuse des impulsions reçues.

Une autre solution connue pour effacer des données optiques consiste à utiliser un amplificateur optique et à le commander électriquement. Ce mode de commande ne permet toutefois pas un fonctionnement très rapide à cause notamment des effets capacitifs au niveau de la commande électrique.

De même, les problèmes de resynchronisation sont jusqu'à présent réalisés de façon électronique, ce qui nécessite des conversions optique-électronique et inversement.

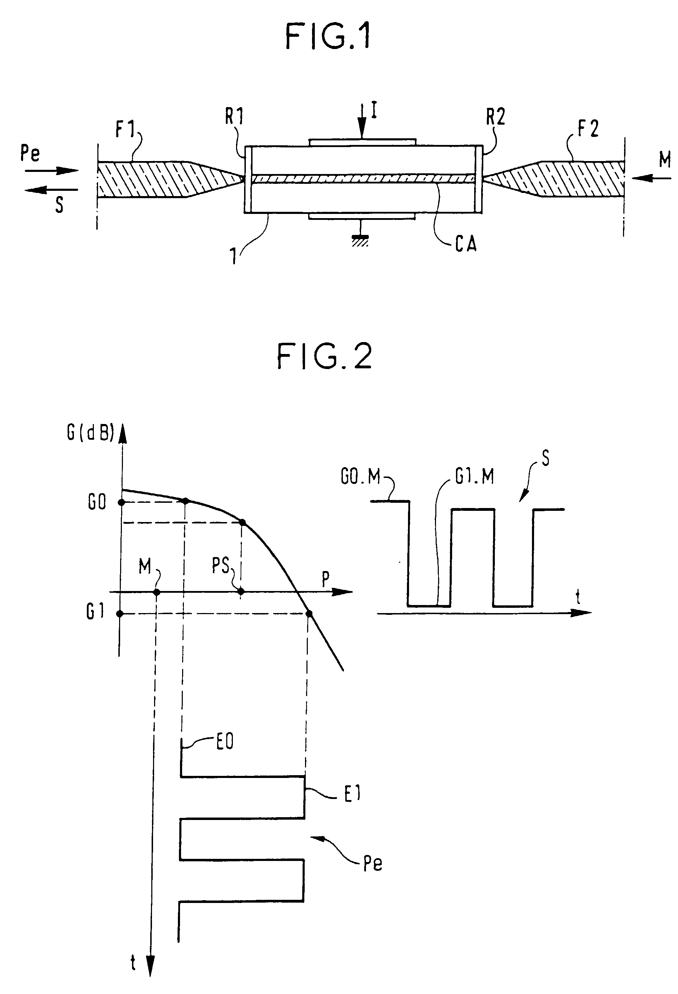

Ainsi, l'invention vise à remédier aux inconvénients des solutions évoquées ci-dessus en proposant une solution entièrement optique permettant un fonctionnement très rapide et de réalisation simple et intégrable. Pour cela il est proposé d'exploiter les propriétés des amplificateurs optiques non linéaires tels que des amplificateurs semiconducteurs, c'est-à-dire ceux présentant un phénomène de saturation qui fait diminuer son gain dynamique lorsque la puissance optique du signal d'entrée augmente. On pourra ainsi utiliser des amplificateurs optiques semiconducteurs qui possèdent naturellement cette propriété. Par ailleurs, un tel amplificateur sera utilisé dans un mode appelé "contradirectionnel" selon lequel des ondes optiques ayant des sens de propagation opposés sont introduites dans l'amplificateur. Une disposition correspondant à ce mode de fonctionnement est illustrée à la figure 1. L'amplificateur 1 comporte une couche active CA à l'intérieur du substrat semiconducteur et dans laquelle on fait circuler un courant I. L'amplificateur 1 comporte deux faces R1 et R2 opposées constituant des ports par l'intermédiaire desquelles on peut appliquer au moyen de fibres optiques F1, F2 deux ondes optiques d'entrée Pe, M opposées. Les faces R1 et R2 étant traitées pour réduire les réflexions, l'amplificateur 1 fournit par l'une de ses faces R1 une onde optique de sortie S résultant pratiquement de l'amplification de la seule onde d'entrée M. L'onde de sortie S a la même longueur d'onde que l'onde d'entrée M, avec une amplitude fonction du degré de saturation de l'amplificateur qui est imposé par le cumul des puissances optiques des deux ondes d'entrée Pe et M.

Un tel amplificateur pourrait également être utilisé dans un mode appelé "codirectionnel" selon lequel les ondes d'entrée sont appliquées à une même face de l'amplificateur. Avec ce mode d'utilisation, on observe bien entendu le même phénomène de saturation mais son exploitation exige que les ondes d'entrée aient des longueurs d'onde suffisamment différentes pour pouvoir filtrer correctement l'onde de sortie S de façon à ne conserver que l'onde amplifiée d'une seule des ondes d'entrée. Ces contraintes n'existent pas en mode contradirectionnel, ce qui permet de se dispenser d'un filtre et d'utiliser des ondes d'entrée de même longueur d'onde.

L'invention se propose donc de tenir compte des remarques précédentes. Plus précisément l'invention a pour objet un procédé pour produire un signal optique de sortie résultant d'une combinaison de plusieurs signaux optiques d'entrée ledit procédé étant caractérisé en ce qu'on utilise un amplificateur optique non linéaire muni d'un port avant et d'un port arrière, en ce qu'une onde optique arrière modulée en amplitude est appliquée audit port arrière, en ce qu'une onde optique avant est appliquée audit port avant, ledit signal de sortie étant représenté par l'onde sortant par ledit port arrière, en ce que la modulation de ladite onde arrière est dimensionnée de façon à pouvoir contrôler la saturation de l'amplificateur et en ce que ladite onde de sortie est séparée de ladite onde arrière en exploitant l'opposition de leurs sens de propagation.

Selon une première possibilité, le procédé peut être adapté pour effectuer l'insertion d'impulsions dans un train d'impulsions reçues. Pour cela, le procédé est en outre caractérisé en ce que l'onde arrière est constituée par une première onde de signal modulée en amplitude et en ce que ladite onde avant est modulée en amplitude de façon à constituer une seconde onde de signal.

Selon une autre possibilité, le procédé est adapté pour effectuer l'effacement sélectif d'impulsions constituant un train d'impulsions reçues. Dans ce cas, le procédé est caractérisé en ce que l'amplitude de ladite onde avant étant fixée à une valeur déterminée, ladite onde arrière résulte de la superposition d'une première onde de signal modulée en amplitude et d'une onde de remise à zéro dont l'amplitude peut prendre une valeur basse ou une valeur haute, en ce que la modulation de ladite onde de signal est modulée de façon à pouvoir contrôler la saturation de l'amplificateur lorsque l'amplitude du signal de remise à zéro est basse et en ce que ladite valeur haute de l'onde de remise à zéro est suffisante pour provoquer la saturation de l'amplificateur indépendamment de l'amplitude de ladite première onde de signal.

Pour traiter ou transmettre un signal synchrone, il est souvent nécessaire de recaler les impulsions de ce signal au moyen d'une horloge de référence. L'invention permettra de résoudre ce problème en prévoyant que ladite onde arrière résulte de la superposition d'une première onde de signal modulée en amplitude entre un premier niveau bas et un premier niveau haut et d'une onde de synchronisation modulée en amplitude entre un second niveau bas et un second niveau haut et en ce que lesdits premier et second niveaux bas et lesdits premier et second niveaux hauts sont choisis de façon à ce que l'amplificateur ne soit pas saturé si et seulement si les amplitudes de ladite première onde de signal et de ladite onde de synchronisation correspondent respectivement auxdits premier et second niveaux bas.

L'invention a également pour objet un dispositif pour la mise en oeuvre du procédé selon l'invention. Le dispositif est caractérisé en ce qu'il comporte

- un amplificateur optique non linéaire muni d'un port avant et d'un port arrière, ledit port avant étant prévu pour recevoir une onde optique avant et
- un séparateur spatial comportant un premier port prévu pour recevoir une onde optique arrière modulée, un second port pour transmettre cette onde optique modulée et un troisième port de sortie, ledit second port étant relié au port arrière de l'amplificateur, ledit troisième port constituant la sortie du dispositif.

D'autres aspects et avantages de l'invention apparaîtront dans la suite de la description en référence aux figures.

- la figure 1 représente schématiquement un amplificateur optique semiconducteur utilisable par l'invention.
- la figure 2 représente une courbe caractéristique du gain de l'amplificateur.
- la figure 3 représente des chronogrammes pour expliquer le procédé selon l'invention dans le cas d'un effacement d'impulsions.
- la figure 4 représente une autre courbe caractéristique du gain de l'amplificateur dans une zone de fonctionnement permettant l'insertion d'impulsions.
- la figure 5 représente des chronogrammes pour expliquer le procédé selon l'invention dans le cas d'insertion d'impulsions.
- la figure 6 représente des chronogrammes permettant d'expliquer le procédé dans le cas d'une resynchronisation.

- la figure 7 représente un mode de réalisation du dispositif selon l'invention.

La courbe représentée à la figure 2 représente les variations du gain G (exprimé en décibels) en fonction de la puissance optique totale P introduite dans la couche active CA de l'amplificateur 1 représenté à la figure 1. Lorsque la puissance totale P est inférieure à une valeur limite Ps, appelée puissance de saturation, le gain G a une valeur élevée peu dépendante de la puissance P. Au-delà de cette valeur, le gain G diminue fortement lorsque la puissance P augmente. En pratique, la puissance de saturation Ps est définie comme la puissance pour laquelle le gain G est inférieur de 3 dB par rapport au gain maximum.

Lorsqu'on introduit par la face avant R2 de l'amplificateur 1 une onde avant M d'amplitude constante et par la face arrière R1 une onde arrière Pe modulée par exemple entre un niveau bas E0 et un niveau haut E1, le gain G de l'amplificateur varie entre une valeur haute GO et une valeur basse G1. L'onde sortante S présente alors une amplitude variant entre les valeurs G0.M et G1.M, en opposition de phase avec l'onde arrière Pe. Ainsi l'onde arrière Pe contrôle la saturation de l'amplificateur 1, et si l'amplitude E1 est suffisante pour saturer fortement l'amplificateur, son gain dynamique diminue, ce qui atténue les effets des fluctuations de l'amplitude E1. Le taux d'extinction augmentant avec la saturation, on préserve ainsi une qualité de signal.

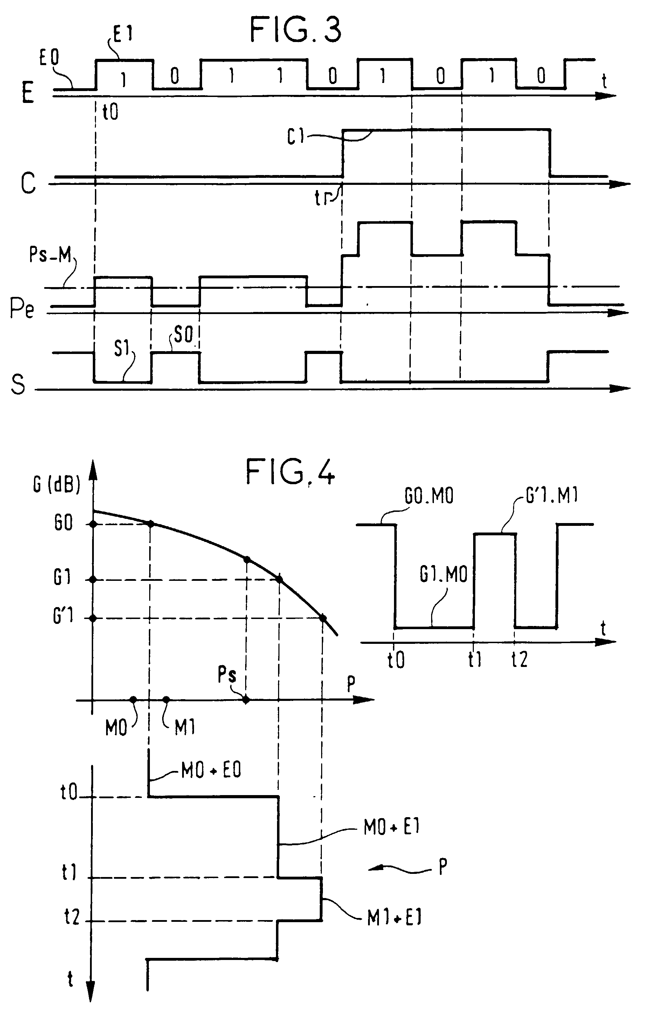

Les chronogrammes représentés à la figure 3 illustrent le cas d'effacement d'impulsions au moyen du procédé selon l'invention. On suppose qu'un signal optique d'entrée E représentant par exemple des données binaires module une porteuse optique pour fournir des impulsions telles que représentées sur la figure. On dispose par ailleurs d'un signal optique de remise à zéro C également modulé en amplitude et restant à son état bas jusqu'à l'instant tr et passant ensuite à un état haut. Par un couplage optique approprié, on superpose les signaux E et C de façon à former l'onde arrière Pe appliquée à la face arrière R1 de l'amplificateur. Si le niveau haut E1 du signal E est suffisant pour que son cumul avec l'onde avant M place l'amplificateur 1 en état de saturation (E1 > Ps -M), on obtiendra une onde de sortie S modulée conformément au chronogramme représenté. Ainsi, jusqu'à l'instant tr, le signal S reproduit le signal E inversé et à partir de tr, tant que C reste à l'état haut, le signal S est forcé à l'état bas.

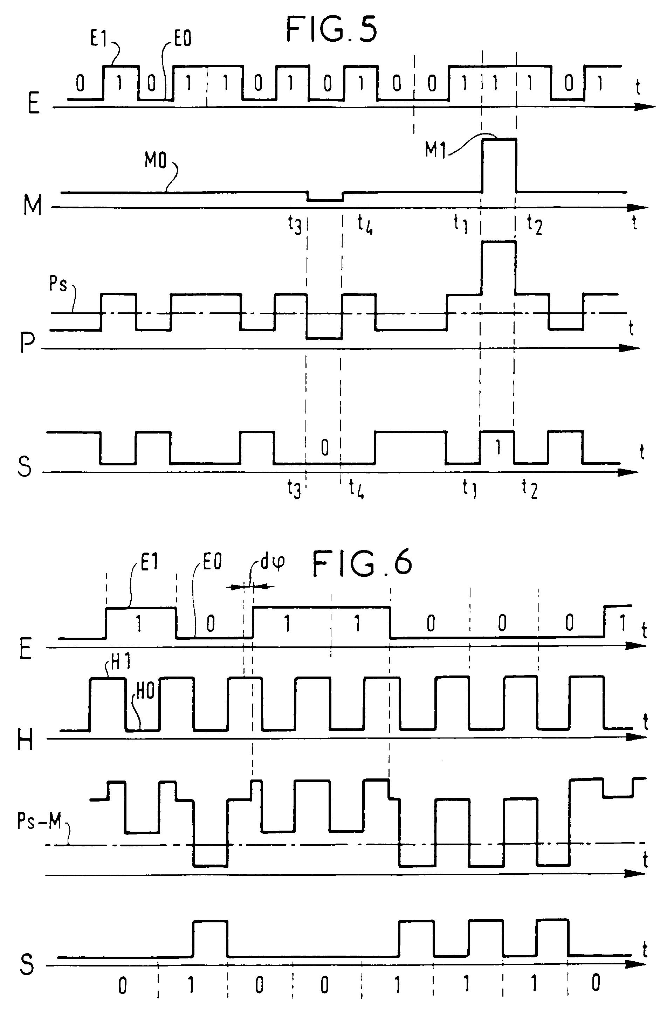

L'insertion d'impulsions va maintenant être décrite en référence aux figures 4 et 5. Nous supposons d'abord que l'onde avant M est modulable entre deux niveaux M0 et M1, M1 étant supérieur à M0. Nous supposons d'autre part que le niveau haut E1 du signal E est suffisamment faible pour assurer dans tous les cas un gain dynamique non nul de l'amplificateur. Ainsi, lorsque l'onde avant M a l'amplitude M0, l'onde de sortie S est modulée comme précédemment entre les niveaux G0.M0 et G1.M0 lorsque le signal E est modulé entre les niveaux E0 et E1. Si maintenant entre les instants t1 et t2 l'amplitude de M prend la valeur M1, l'onde de sortie S aura entre ces instants l'amplitude G'1.M1, G'1 correspondant au gain de l'amplificateur lorsque P = N1+ E1. On réalise ainsi l'insertion dans le signal S d'une impulsion obtenue par simple modulation de l'onde avant M. L'amplitude M1 pourra avantageusement être choisie de façon à ce que l'impulsion insérée ait une amplitude sensiblement égale à celle des impulsions normales.

On peut noter qu'il est également possible de supprimer une impulsion en abaissant suffisamment l'amplitude de l'onde avant M. Ce cas est représenté sur le chronogramme entre les instants t3 et t4.

Le cas de la resynchronisation d'un train d'impulsions est représenté à la figure 6. On suppose que le signal E peut présenter des fluctuations de phase dφ et doit être recalé sur le signal d'horloge H. Pour cela on superpose ces signaux de façon à constituer l'onde arrière Pe. On choisira les niveaux bas E0 et H0 et les niveaux hauts E1 et H1 respectivement des signaux E et H de façon à respecter les conditions :

$$E0 + H0 < P_s - M$$

$$E1 + H0 > P_s - M$$

$$E0 + H1 > P_s - M$$

On obtiendra alors l'onde resynchronisée S telle que représentée sur le chronogramme. On peut remarquer que la resynchronisation effectuée s'accompagne d'une transformation d'une modulation du type NRZ (non retour à 0) en une modulation RZ(retour à 0). On pourra alors reconstituer une modulation de type NRZ à partir du signal S par simple filtrage passe-bas. Avantageusement, H1 sera choisi supérieur à E1.

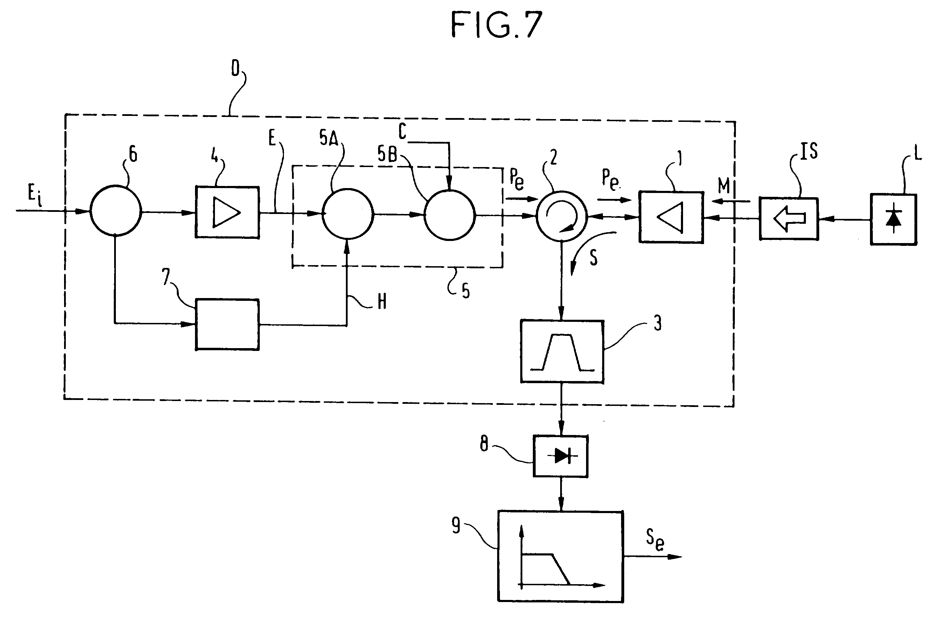

Un exemple de réalisation du dispositif selon l'invention est représenté à la figure 7. Le dispositif D comporte un amplificateur optique semiconducteur 1 d'un type déjà décrit précédemment. Sa face avant est prévue pour recevoir l'onde avant M. Un séparateur spatial, tel qu'un circulateur 2 comporte un premier et un second ports prévus respectivement pour recevoir et transmettre une onde optique arrière Pe. Le second port du circulateur est relié à la face arrière de l'amplificateur par l'intermédiaire d'une fibre optique. Un troisième port du circulateur 2 fournit l'onde de sortie S qui est l'onde avant M amplifiée.

Afin d'améliorer la pureté du signal de sortie, le port de sortie du circulateur 2 sera avantageusement relié à un filtre optique 3 dont la bande passante est centrée sur la longueur d'onde de l'onde avant M.

Il est à noter que le rôle principal de ce filtre n'est pas de supprimer les réflexions parasites de l'onde arrière Pe mais plutôt d'éliminer les effets des émissions spontanées se produisant dans l'amplificateur.

Le premier port du circulateur 2 est relié à la sortie de moyen de couplage 5 recevant en entrée une onde de signal E à traiter, une onde de remise à zéro C et une onde de synchronisation H. Les moyens de couplage 5 sont par exemple réalisés au moyen d'un premier coupleur optique 5A recevant en entrée les ondes E et H et d'un second coupleur optique 5B recevant en entrée l'onde de sortie du coupleur 5A et l'onde C.

si nécessaire, on pourra ajuster les niveaux hauts du signal E en prévoyant un amplificateur optique 4 inséré entre le signal reçu à traiter Ei et l'entrée des moyens de couplage 5.

L'onde optique de synchronisation H peut être fournie par un dispositif de récupération de signal d'horloge 7. Dans le cas d'une réalisation entièrement optique, le dispositif 7 comportera un laser autodéclenché recevant en entrée le signal Ei par l'intermédiaire d'un coupleur 6.

L'onde avant M pourra être fournie par une source laser L modulable reliée à la face avant de l'amplificateur 1 par l'intermédiaire d'un isolateur IS. Enfin la sortie du filtre optique 3 pourra être reliée à un détecteur 8 servant de convertisseur optique-électrique dont la sortie est reliée à un filtre passe-bas électronique 9 fournissant le signal Se.

Le fonctionnement du dispositif a déjà été expliqué précédemment. On peut toutefois ajouter que les longueurs d'onde des ondes impliquées peuvent être aussi bien identiques que différentes entre elles.

Bien entendu, diverses variantes à ce mode de réalisation peuvent être apportées sans pour cela sortir du cadre de la présente invention. Ainsi, dans le cas où la fonction de resynchronisation ne serait pas utilisée, on pourrait supprimer les coupleurs 5A et 6 ainsi que le dispositif 7. De même si la fonction de remise à zéro n'était pas utilisée, on pourrait supprimer le coupleur 5B. Enfin, si seule la fonction d'insertion d'impulsions était utilisée, on pourrait supprimer les moyens de couplage 5, le coupleur 6 et le dispositif de récupération de signal d'horloge 7.

## Revendications

**1.** Procédé pour produire un signal optique de sortie (S) résultant d'une combinaison de plusieurs signaux optiques d'entrée (E, C, M, H), ledit procédé étant caractérisé en ce qu'on utilise un amplificateur optique (1) non linéaire muni d'un port avant (R2) et d'un port arrière (R1), en ce qu'une onde optique arrière (Pe) modulée en amplitude est appliquée audit port arrière (R1), en ce qu'une onde optique avant (M) est appliquée audit port avant (R2), ledit signal de sortie étant représenté par l'onde (S) sortant par ledit port arrière (R1), en ce que la modulation de ladite onde arrière (Pe) est dimensionnée de façon à pouvoir contrôler la saturation de l'amplificateur (1) et en ce que ladite onde de sortie (S) est séparée de ladite onde arrière (Pe) en exploitant l'opposition de leurs sens de propagation.

2. Procédé selon la revendication 1, caractérisé en ce que l'onde arrière (Pe) est constituée par une première onde de signal (E) modulée en amplitude et en ce que ladite onde avant (M) est modulée en amplitude de façon à constituer une seconde onde de signal.

3. Procédé selon la revendication 2, caractérisé en ce que la modulation de ladite première onde de signal (E) est dimensionnée de façon à assurer à l'amplificateur (1) un gain suffisant pour pouvoir transmettre la modulation de ladite onde avant (M) modulée.

4. Procédé selon la revendication 2, caractérisé en ce que ladite onde avant (M) est modulée entre un premier niveau d'amplitude (M0) permettant à ladite première onde de signal (E) de contrôler la saturation de l'amplificateur (1) et un second niveau d'amplitude très faible ou nulle.

5. Procédé selon la revendication 1, caractérisé en ce que l'amplitude de ladite onde avant (M) étant fixée à une valeur déterminée, ladite onde arrière (Pe) résulte de la superposition d'une première onde de signal (E) modulée en amplitude et d'une onde de remise à zéro (C) dont l'amplitude peut prendre une valeur basse ou une valeur haute (C1), en ce que la modulation de ladite onde de signal (E) est modulée de façon à pouvoir contrôler la saturation de l'amplificateur (1) lorsque l'amplitude du signal de remise à zéro (C) est basse et en ce que ladite valeur haute (C1) de l'onde de remise à zéro (C) est suffisante pour provoquer la saturation de l'amplificateur (1) indépendamment de l'amplitude de ladite première onde de signal (E).

6. Procédé selon la revendication 1, caractérisé en ce que ladite onde arrière (Pe) résulte de la superposition d'une première onde de signal (E) modulée en amplitude entre un premier niveau bas (E0) et un premier niveau haut (El) et d'une onde de synchronisation H modulée en amplitude entre un second niveau bas (H0) et un second niveau haut (H1) et en ce que lesdits premier et second niveaux bas (E0, H0) et lesdits premier et second niveaux hauts (E1, H1) sont choisis de façon à ce que l'amplificateur (1) ne soit pas saturé si et seulement si les amplitudes de ladite première onde de signal (E) et de ladite onde de synchronisation (H) correspondent respectivement auxdits premier et second niveaux bas (E0, H0).

7. Dispositif pour la mise en oeuvre du procédé selon l'une des revendications 1 à 6, caractérisé en ce qu'il comporte :

- un amplificateur optique non linéaire (1) muni d'un port avant (R2) et d'un port arrière (R1), ledit port avant (R2) étant prévu pour recevoir une onde optique avant (M) et
- un séparateur spatial (2) comportant un premier port prévu pour recevoir une onde optique arrière (Pe) modulée, un second port pour transmettre cette onde optique modulée et un troisième port de sortie, ledit second port étant relié au port arrière (R1) de l'amplificateur (1), ledit troisième port constituant la sortie du dispositif.

8. Dispositif selon la revendication 7, caractérisé en ce que ledit port de sortie du séparateur spatial (2) est relié à l'entrée d'un filtre optique (3) dont la bande passante est centrée sur la longueur d'onde de ladite onde avant (M).

9. Dispositif selon l'une des revendications 7 ou 8, caractérisé en ce que ledit premier port du séparateur spatial (2) est relié à la sortie de moyens de couplage optique (5) comportant une pluralité d'entrées.

10. Dispositif selon la revendication 9, caractérisé en ce que l'une desdites entrées desdits moyens de couplage optique (5) est reliée à la sortie d'un amplificateur optique d'entrée (4).

11. Dispositif selon l'une des revendications 9 ou 10, caractérisé en ce qu'il comporte un dispositif optique de récupération de signal d'horloge (7) dont la sortie est reliée auxdits moyens de couplage optique (5).

**Patentansprüche**

1. Verfahren zum Erzeugen eines optischen Ausgangssignals (S), das aus einer Kombination von mehreren optischen Eingangssignalen (E, C, M H) resultiert, dadurch gekennzeichnet, dass ein nichtlinearer optischer Verstärker (1) verwendet wird, der mit einem vorderen Anschluss (R2) und einem hinteren Anschluss (R1) versehen ist, dass eine amplitudenmodulierte hintere optische Welle (Pe) an den hinteren Anschluss (R1) angelegt wird, dass eine vordere optische Welle (M) an den vorderen Anschluss (R2) angelegt wird, wobei das Ausgangssignal dargestellt ist durch die Welle (S), die durch den hinteren Anschluss (R1) austritt, dass die Modulation der hinteren Welle (Pe) so dimensioniert ist, dass die Sättigung des Verstärkers (1) steuerbar ist, und dass die Ausgangswelle (S) von der hinteren Welle (Pe) durch Ausnutzung ihrer gegenläufigen Ausbreitungsrichtungen getrennt wird.

2. Verfahren nach Anspruch 1, dadurch gekennzeichnet, dass die hintere Welle (Pe) durch eine erste amplitudenmodulierte Signalwelle (E) gebildet wird, und dass die vordere Welle (M) amplitudenmoduliert wird, um eine zweite Signalwelle zu bilden.

3. Verfahren nach Anspruch 2, dadurch gekennzeichnet, dass die Modulation der ersten Signalwelle (E) so dimensioniert ist, dass für den Verstärker (1) eine Verstärkung gewährleistet ist, die ausreicht, um die Modulation der modulierten vorderen Welle (M) übertragen zu können.

4. Verfahren nach Anspruch 2, dadurch gekennzeichnet, dass die vordere Welle (M) zwischen einem ersten Amplitudenniveau (M0), das es der ersten Signalwelle (E) erlaubt, die Sättigung des Verstärkers (1) zu steuern, und einem zweiten, sehr geringen oder verschwindenden Amplitudenniveau moduliert wird.

5. Verfahren nach Anspruch 1, dadurch gekennzeichnet, dass wenn die Amplitude der vorderen Welle (M) auf einen gegebenen Wert festgelegt ist, die hintere Welle (Pe) aus der Überlagerung einer ersten amplitudenmodulierten Signalwelle (E) und einer Nullrückstellwelle (C), deren Amplitude einen niedrigen Wert oder einen hohen Wert (C1) annehmen kann, resultiert, dass die Modulation der Signalwelle (E) moduliert wird, um die Sättigung des Verstärkers (1) steuern zu können, wenn die Amplitude des Nullrückstellsignals (C) niedrig ist, und dass der hohe Wert (C1) der Nullrückstellwelle (C) ausreichend ist, um die Sättigung des Verstärkers (1) unabhängig von der Amplitude der ersten Signalwelle (E) hervorzurufen.

6. Verfahren nach Anspruch 1, dadurch gekennzeichnet, dass die hintere Welle (Pe) aus der Überlagerung einer ersten Signalwelle (E), die zwischen einem ersten niedrigen Niveau (E0) und einem ersten hohen Niveau (E1) amplitudenmoduliert ist, und einer Synchronisationswelle H resultiert, die zwischen einem zweiten niedrigen Niveau (H0) und einem zweiten hohen Niveau (H1) amplitudenmoduliert ist, und dass das erste und zweite niedrige Niveau (E0, H0) und das erste und zweite hohe Niveau (E1, H1) so gewählt sind, dass der Verstärker (1) nicht gesättigt wird, wenn und nur wenn die Amplituden der ersten Signalwelle (E) und der Synchronisationswelle (H) jeweils dem ersten bzw. zweiten niedrigen Niveau (E0, H0) entsprechen.

7. Vorrichtung für die Anwendung des Verfahrens nach einem der Ansprüche 1 bis 6, dadurch gekennzeichnet, dass sie umfasst:

- einen nichtlinearen optischen Verstärker (1), der mit einem vorderen Anschluss (R2) und einem hinteren Anschluss (R1) versehen ist, wobei der vordere Anschluss (R2) vorgesehen ist, um eine vordere optische Welle (M) zu empfangen, und

- einem räumlichen Trenner (2), der einen ersten Anschluss, der vorgesehen ist, um eine modulierte hintere optische Welle (Pe) zu empfangen, einen zweiten Anschluss zum Übertragen dieser modulierten optischen Welle und einen dritten Ausgangsanschluss umfasst, wobei der zweite Anschluss mit dem hinteren Anschluss (R1) des Verstärkers (1) verbunden ist und der dritte Anschluss den Ausgang der Vorrichtung bildet.

8. Vorrichtung nach Anspruch 7, dadurch gekennzeichnet, dass der Ausgangsanschluss des räumlichen Trenners (2) mit dem Eingang eines optischen Filters (3) verbunden ist, dessen Durchgangsband auf die Wellenlänge der vorderen Welle (M) zentriert ist.

9. Vorrichtung nach einem der Ansprüche 8 oder 9, dadurch gekennzeichnet, dass der erste Anschluss des räumlichen Trenners (2) an den Ausgang von optischen Koppelmitteln (5) angeschlossen ist, die eine Mehrzahl von Eingängen umfassen.

10. Vorrichtung nach Anspruch 9, dadurch gekennzeichnet, dass einer der Eingänge der optischen Koppelmittel (5) an den Ausgang eines optischen Eingangsverstärkers (4) angeschlossen ist.

11. Vorrichtung nach einem der Ansprüche 9 oder 10, dadurch gekennzeichnet, dass sie eine optische Taktsignal-Wiedergewinnungsvorrichtung (7) umfasst, deren Ausgang an die optischen Koppelmittel (5) angeschlossen ist.

**Claims**

1. Method of producing an optical output signal (S) by combining a plurality of optical input signals (E, C, M, H) using a non-linear optical amplifier (1) having a front port (R2) and a rear port (R1), in which method an amplitude modulated rear optical wave (Pe) is applied to said rear port (R1), a front optical wave (M) is applied to said front port (R2), said output signal is the wave (S) output via said rear port (R1), the modulation of said rear wave (Pe) is such as to enable control of the saturation of said amplifier (1) and said output wave (S) is separated from said rear wave (Pe) by exploiting the fact that their propagation directions are opposite.

**2.** Method according to claim 1, characterized in that said rear wave (Pe) is an amplitude modulated first signal wave (E) and said front wave (M) is amplitude modulated to constitute a second signal wave.

**3.** Method according to claim 2, characterized in that said first signal wave (E) is modulated so as to impart to said amplifier (1) sufficient gain to transmit the modulation of said modulated front wave (M).

**4.** Method according to claim 2, characterized in that said front wave (M) is modulated between a first amplitude (M0) enabling said first signal wave (E) to control the saturation of said amplifier (1) and a very low or zero second amplitude.

**5.** Method according to claim 1, characterized in that, the amplitude of said front wave (M) being fixed at a particular value, said rear wave (Pe) is the result of superposing an amplitude modulated first signal wave (E) and a reset to zero wave (C) the amplitude of which can assume a low value or a high value (C1), the modulation of said signal wave (E) is such as to enable control of the saturation of said amplifier (1) when the amplitude of said reset to zero signal (C) is low and said high value (C1) of said reset to zero wave (C) is sufficient to saturate said amplifier (1) independently of the amplitude of said first signal wave (E).

**6.** Method according to claim 1, characterized in that said rear wave (Pe) is the result of superposing a first signal wave (E) amplitude modulated between a first low level (E0) and a first high level (E1) and a synchronization wave H amplitude modulated between a second low level (H0) and a second high level (H1) and said first and second low levels (E0, H0) and said first and second high levels (E1, H1) are such that the amplifier (1) is not saturated if and only if the amplitudes of said first signal wave (E) and said synchronization wave (H) respectively correspond to said first and second low levels (E0, H0).

**7.** Device for implementing the method according to any one of claims 1 to 6, comprising:

- a non-linear optical amplifier (1) having a front port (R2) and a rear port (R1), said front port (R2) being adapted to receive a front optical wave (M), and
- a spatial separator (2) comprising a first port for receiving a modulated rear optical wave (Pe), a second port for transmitting said modulated optical wave and an output third port, said second port being connected to said rear port (R1) of said amplifier (1) and said third port constituting the output of said device.

**8.** Device according to claim 7, characterized in that said output port of said spatial separator (2) is connected to the input of an optical filter (3) the bandwidth of which is centered on the wavelength of said front wave (M).

**9.** Device according to claim 7 or claim 8, characterized in that said first port of said spatial separator (2) is connected to the output of optical coupling means (5) having a plurality of inputs.

**10.** Device according to claim 9, characterized in that one of said inputs of said optical coupling means (5) is connected to the output of an input optical amplifier (4).

**11.** Device according to claim 9 or claim 10 including an optical clock signal recovery device (7) the output of which is connected to said optical coupling means (5).

# FIG.1

# FIG.2

# FIG.3

# FIG.4

# FIG.5

# FIG.6

# FIG.7